Europäisches Patentamt

European Patent Office

Office européen des brevets

(19)

(11) EP 1 337 049 A2

(12) **EUROPEAN PATENT APPLICATION**

(43) Date of publication:
   **20.08.2003 Bulletin 2003/34**

(51) Int Cl.⁷: **H04B 1/40**, H03G 3/30

(21) Application number: **03002507.6**

(22) Date of filing: **04.02.2003**

| | |
|---|---|
| (84) Designated Contracting States:<br>**AT BE BG CH CY CZ DE DK EE ES FI FR GB GR HU IE IT LI LU MC NL PT SE SI SK TR**<br>Designated Extension States:<br>**AL LT LV MK RO** | (71) Applicant: **NEC CORPORATION**<br>**Tokyo (JP)** |
| (30) Priority: **06.02.2002 JP 2002029864** | (72) Inventor: **Yamamoto, Osamu**<br>**Minato-ku, Tokyo (JP)**<br><br>(74) Representative: **VOSSIUS & PARTNER**<br>**Siebertstrasse 4**<br>**81675 München (DE)** |

(54) **Radio base station**

(57)    There is provided a radio base station which can automatically correct variation in gain of a mast head amplifier and variation in transmission loss due to the length, type and maintenance conditions of a feeder and can minimize an error of the gain of a received signal.

The radio base station of the present invention has a terminating set and an antenna and includes a mast head amplifier selecting any one signal of a first signal inputted from the terminating set and a second signal inputted from the antenna to amplify and output it. The radio base station of the present invention also includes a base station receiver connected to the mast head amplifier adjusting an intensity of the first signal so that the intensity of the first signal is a predetermined value to set a first gain of the first signal when inputting the first signal from the mast head amplifier, and adjusting an intensity of the second signal based on the set first gain when inputting the second signal from the mast head amplifier.

FIG. 2

EP 1 337 049 A2

**Description**

The present invention relates to a radio base station. More specifically, the present invention relates to a radio base station which can precisely set the gain of an input signal.

A technique related to an automatic transmission cable loss compensating system is described in JP-U- 62-75653.

In the prior art, an automatic transmission cable loss compensating system is provided with means for discriminating cable length at at least one terminal of a connector provided at the reception side end of a transmission cable having a plurality of signal transmission lines bound therein. It is provided with a gain control amplifier for compensating for the transmission loss of an input signal in a receiver. When the connector is coupled to the receiver, the gain of the gain control amplifier corresponding to the cable length is controlled to automatically compensate for the transmission cable loss.

A technique related to a transmitting power controller is described in JP-A-1-143411.

In the prior art, a transmitter amplifies or frequency converts an input signal for transmission. In the transmitter, a transmitting power controller is provided with a comparator and a hold circuit.

The comparator configures an ALC loop by an input level detector detecting the level of the input signal, an output level detector detecting the level of a transmitted output signal, and means controlling the gain of the transmitter based on a detected value of each of the level detectors, and compares the input level with a reference value. The hold circuit brings the operation of the ALC loop into a fixed state.

When the input level is below the reference value in the comparator, the hold circuit is driven to fix the gain of the ALC loop by a value immediately before it.

A technique related to an automatic transmission cable loss compensating system is described in JP-U- 6-38508.

In the prior art, in a signal transmission system, a transmitter transmits a signal via a transmission cable to a receiver. The transmitter side has high frequency oscillation means oscillating a high frequency signal in a predetermined period, high frequency superimposition means superimposing the high frequency signal oscillated by the high frequency oscillation means on a transmission signal, and a first switch connected between the high frequency oscillation means and the high frequency superimposition means.

The receiver side has high frequency detection means detecting the high frequency signal transmitted from the transmitter side via the transmission cable, and cable length discrimination means discriminating cable length by the detected output level obtained from the high frequency detection means. The receiver side also has gain control means controlling the gain of the transmitted signal based on the discriminated output by the cable length discrimination means, and a second switch connected between the high frequency detection means and the gain control means.

A technique related to a receiver is described in JP-A- 11-205056.

In the prior art, a receiver has a receiving antenna receiving an incoming communication electric wave to obtain a received signal, and a receiver body decoding the received signal to obtain a decoded signal. The receiver also has a coaxial cable connecting the receiving antenna and the receiver body and transmitting the received signal between the receiving antenna and the receiver body, and an amplifier amplifying the level of the received signal to compensate for the transmission loss of the coaxial cable.

The receiver body has variable attenuation means adjusting the level of the received signal transmitted from the coaxial cable to the receiver body. The receiver body also has control means controlling the variable attenuation means so that the total of the gain of the amplifier, the gain of the coaxial cable and the gain of the variable attenuation means is a predetermined value by the variable attenuation means.

A technique related to a base station which is connected to an antenna away from a base station is described in JP-A- 2000-514976.

In the prior art, a base station of a radio system has a base station device including at least one transmitter unit. The base station of a radio system has antenna means for receiving a signal given by the transmitter unit which may be away from the base station device and is connected to the transmitter unit of the base station device by at least one cable.

The antenna means has amplification means for amplifying the signal received from the transmitter unit via the cable and means for transmitting the amplified signal to a receiver unit in the radio coverage area of the base station.

The amplification means has a variable gain amplifier, a first sampling means for sampling a signal given to the input of the amplifier via the cable, and a second sampling means for sampling the signal transmitted from the amplifier to an antenna. The amplification means has adjusting means for adjusting the gain of the amplifier to obtain a fixed gain in response to the first and second sampling means.

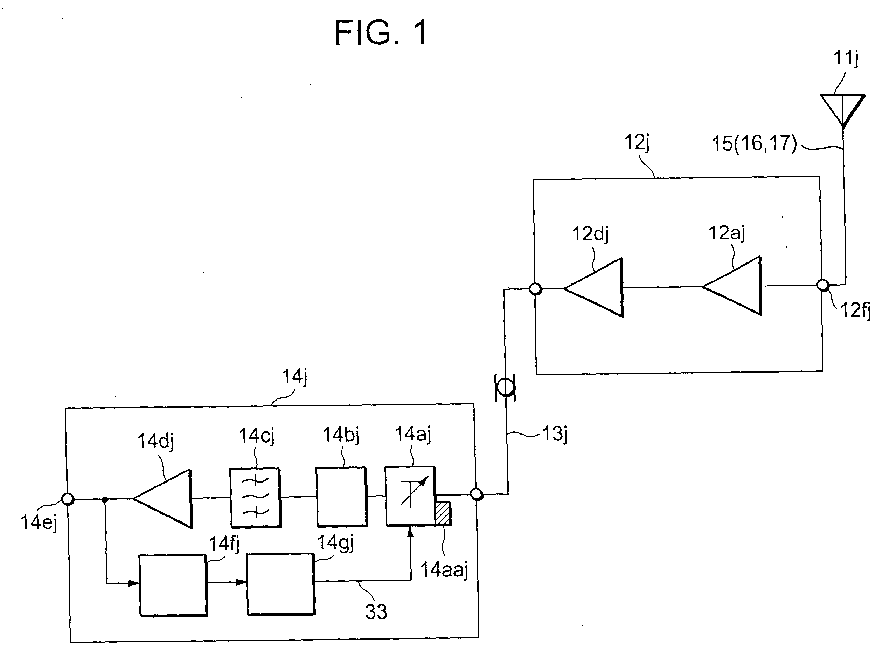

Based on FIG.1, the construction of a prior art radio base station 10j according to a radio base station 10 of the present invention will be described in detail.

The prior art radio base station 10j has an antenna 11j, a mast head amplifier 12j, a base station receiver 14j, and a feeder (coaxial cable) 13j connecting the mast head amplifier 12j and the base station receiver 14j.

The mast head amplifier 12j is installed to increase the effective sensitivity of an induced signal 15 in the base station receiver 14j and has a first first-stage amplifier 12aj, an amplifier 12dj, and an input terminal 12fj. The base station receiver 14j has a variable attenuator 14aj, a frequency converter 14bj, an intermediate frequency filter 14cj, an intermediate frequency amplifier 14dj, an output terminal 14ej, a detector 14fj, and a controller 14gj.

The first first-stage amplifier 12aj is connected to the antenna 11j via the input terminal 12fj and inputted the induced signal 15 from the antenna 11j. The amplifier 12dj amplifies the induced signal 15 inputted from the first first-stage amplifier 12aj, and outputs it to the variable attenuator 14aj. The induced signal 15 corresponds to a power induced by an electric wave received by the antenna 11j.

The variable attenuator 14aj adjusts the induced signal 15 outputted from the amplifier 12dj. The frequency converter 14bj converts the frequency of the induced signal 15 outputted from the variable attenuator 14aj. The intermediate frequency filter 14cj removes unnecessary frequencies from the induced signals 15 which is frequency-converted by the frequency converter 14bj.

The intermediate frequency amplifier 14dj amplifies the induced signal 15 via the intermediate frequency filter 14cj. The induced signal which is amplified by the intermediate frequency amplifier 14dj is outputted to the output terminal 14ej.

The detector 14fj detects an output power 18 (outputted from the intermediate frequency amplifier 14dj) at the output terminal 14ej to output the detected result to the controller 14gj. When inputting the output power 18 from the detector 14fj, the controller 14gj outputs a power notification signal 33 including information showing the output power 18 to the variable attenuator 14aj to control the variable attenuator 14aj. By said control, the output power 18 at the output terminal 14ej is adjusted to a predetermined value.

The radio base station 10j must precisely set a received gain to optimize thermal noise and distortion noise for preciselymeasure of a reception level. The amplification degree (or gain) of the induced signal 15 is not always fixed via the mast head amplifier 12j and the base station receiver 14j. This is caused mainly by variation in gain of the mast head amplifier 12j and variation in transmission loss (attenuation) due to the length, type and maintenance conditions of the feeder 13j.

Efforts are being made to minimize the variation in gain of the mast head amplifier 12j by adjustment at the manufacturing stage of the mast head amplifier 12j. For this reason, the mast head amplifier 12j is more expensive.

There is employed a method for correcting the variation in transmission loss by measuring the length of the feeder 13j for each of the radio base stations 10j and manually adjusting an amplification factor of the amplifier (or an attenuation factor of the attenuator) included in the mast head amplifier 12j and the base station receiver 14j in consideration of the type of the feeder 13j.

The method has the following problems:

(1) It takes time to measure the length of the feeder 13j;
(2) When the feeders 13j of different types are connected in series, the transmission loss cannot be easily estimated;
(3) When maintenance of the feeder 13j is failed, the transmission loss can be increased than expected; and
(4) Erroneous manual adjustment and correction of the amplification factor of the amplifier cannot be found.

An object of the present invention is to provide a radio base station which can automatically correct variation in gain of a mast head amplifier.

Another object of the present invention is to provide a system which can automatically correct variation in transmission loss due to the length, type and maintenance conditions of a feeder.

A further object of the present invention is to provide a radio base station which can minimize an error of the gain of a received signal.

These objects are achieved with the features of the claims.

Further aspects of the invention are described below:

A radio base station (10) of the present invention has a terminating set (12e) and an antenna (11), and includes a mast head amplifier (12) amplifying and outputting any one signal (22) of a first signal (21) inputted from the terminating set (12e) and a second signal (15) inputted from the antenna (11). The radio base station (10) of the present invention also includes a base station receiver (14) connected to the mast head amplifier (12) adjusting an intensity (24) of the first signal (21) so that the intensity (24) of the first signal (21) is a predetermined value (25) to set a first gain (30) of the first signal (21) when inputting the first signal (21) from the mast head amplifier (12), and adjusting an intensity (19) of the second signal (15) based on the set first gain (30) when inputting the second signal (15) from the mast head amplifier (12).

The radio base station (10) of the present invention further includes a feeder (13) connecting the mast head amplifier (12) and the base station receiver (14) and transmitting the first signal (21) to output it to the base station receiver (14) when inputting the first signal (21) from the mast head amplifier (12). The base station receiver (14) adjusts the intensity (24) of the first signal (21) inputted fromthe feeder (13) based on the predetermined value (25) and an attenuation (27) when the first signal (21) is transmitted via the feeder (13).

In the radio base station (10) of the present invention, the feeder (13) transmits the second signal (15) to output it to the base station receiver (14) when inputting the second signal (15) from the mast head amplifier (12). The base station receiver (14) adjusts the intensity (19) of the second signal (15) inputted from the feeder (13) based on the set first gain (30).

In the radio base station (10) of the present invention, the mast head amplifier (12) includes a first first-stage amplifier (12a) connected to the terminating set (12e) amplifying and outputting the first signal (21) inputted from the terminating set (12e) and a second first-stage amplifier (12b) connected to the antenna (11) amplifying and outputting the second signal (15) inputted from the antenna (11). The mast head amplifier (12) also includes a switch (12c) selecting any one first-stage amplifier of the first first-stage amplifier (12a) and the second first-stage amplifier (12b). The mast head amplifier (12) further includes a first amplifier (12d) connecting the first-stage amplifier and the feeder (13) and amplifying the signal (22) outputted from the first-stage amplifier selected by the switch (12c) to output it to the feeder (13).

In the radio base station (10) of the present invention, the mast head amplifier (12) includes the second first-stage amplifier (12b) connected to the antenna (11) amplifying and outputting the second signal (15) inputted from the antenna (11) and the switch (12c) selecting any one device of the second first-stage amplifier (12b) and the terminating set (12e). The mast head amplifier (12) also includes the first amplifier (12d) connecting the device and the feeder (13) and amplifying the signal (22) outputted from the device selected by the switch (12c) to output it to the feeder (13).

In the radio base station (10) of the present invention, the base station receiver (14) includes an attenuator (14h) adjusting the intensity (24) of the first signal (21) inputted from the feeder (13) based on the predetermined value (25) and the attenuation (27) when inputting the first signal (21) from the mast head amplifier (12) to set the first gain (30), and adjusting the intensity (19) of the second signal (15) based on the set first gain (30) when inputting the second signal (15) from the mast head amplifier (12).

In the radio base station (10) of the present invention, the base station receiver (14) includes a detection part (14f) detecting the intensity (24) of the first signal (21) outputted from the base station receiver (14), and a control part (14g) controlling the attenuator (14a) based on an intensity (28) of the first signal (21) detected by the detection part (14f) and the predetermined value (25) when inputting the first signal (21) to the detection part (14f). The base station receiver (14) also includes an alarm generation part (14aa) generating an alarm for notifying abnormality when the attenuation of the signal (22) of the attenuator (14a) is not within a predetermined range.

As described above, the radio base station of the present invention can automatically correct variation in gain of the mast head amplifier.

The radio base station of the present invention which can automatically correct variation in transmission loss due to the length, type and maintenance conditions of the feeder 13.

The radio base station of the present invention which can minimize an error of the gain of a received signal of the radio base station.

Preferred embodiments of the present invention will be described below in detail with reference to the drawings.

FIG. 1 is a diagram showing a prior art construction according to the radio base station of the present invention;
FIG. 2 is a diagram showing a construction including a switch according to Embodiment 1 of a radio base station of the present invention;
FIG. 3 is a diagram showing a construction not including a switch according to Embodiment 1 of the radio base station of the present invention; and
FIG. 4 is a diagram showing a construction according to Embodiment 2 of the radio base station of the present invention.

Embodiment 1

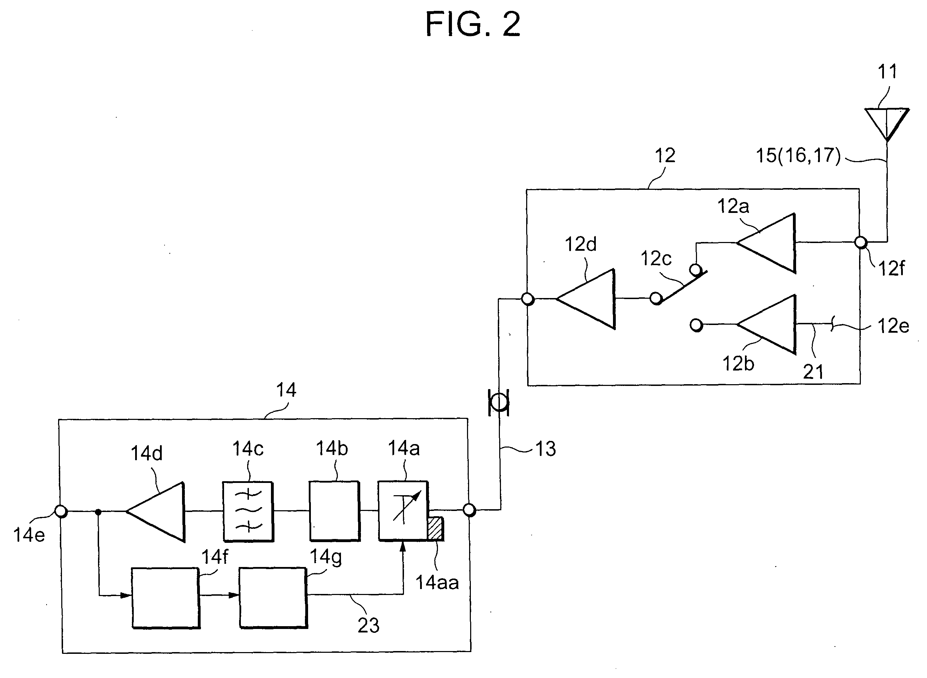

Embodiment 1 according to a radio base station 10 of the present invention will be described. As shown in FIG. 2, the radio base station 10 has an antenna 11, a mast head amplifier 12, a feeder 13, and a base station receiver 14. FIG. 2 shows a detailed circuit construction of the mast head amplifier 12 and the base station receiver 14. In FIG. 2, the numeral 15 (16, 17) shows that an induced signal 15 includes a signal 16 and a first noise signal 17 (which will be described later).

The antenna 11 receives an electric wave (including the later-described signal 16 and first noise signal 17) from a cellular phone located in an area covered by the radio base station 10. A power is induced from the electric wave received by the antenna 11. The antenna 11 outputs the induced power (hereinafter, called an "induced power") to a first first-stage amplifier 12a.

The induced power is expressed by the sum of a signal power and a first noise signal power. The signal power corresponds to the signal 16 showing information (hereinafter, called "input information") inputted to the cellular phone. The first noise power is a power corresponding to a noise (irregular signal) produced in the process that the input information inputted to the cellular phone is transmitted to the antenna 11 of the radio base station 10 to be outputted to the first first-stage amplifier 12a.

Hereinafter, a signal included in an induced electric wave (the synthesis of a signal wave and a first noise electric wave) as a source of the induced power is expressed as the "induced signal 15" and a signal included in the signal electric wave as a source of the signal power is simply expressed as the "signal 16". A signal included in the first noise electric wave as a source of the first noise power is expressed as the "first noise signal 17".

Hereinafter, a power corresponding to the induced power is expressed as an "output power 18"; a power corresponding to the signal power, a "signal power 19"; and a power corresponding to the first noise power, a "first noise power 20".

The mast head amplifier 12 is installed to increase the effective sensitivity of the induced signal 15 in the base station receiver 14 and has the first first-stage amplifier 12a, a second first-stage amplifier 12b, a switch 12c, an amplifier 12d, a terminating set 12e, and an input terminal 12f.

The first first-stage amplifier 12a is connected to the antenna 11 via the input terminal 12f to input the induced signal 15 from the antenna 11. The second first-stage amplifier 12b is not connected to the antenna 11 and has an input terminated by the terminating set 12e. The switch 12c connects the amplifier 12d and any one first-stage amplifier of the first first-stage amplifier 12a and the second first-stage amplifier 12b and switches the connection to select any one of the first-stage amplifiers.

The amplifier 12d amplifies any one of the induced signal 15 and a second noise signal 21 (The second noise signal 21 is a signal included in a noise outputted from the terminating set 12e.) inputted via the switch 12c and outputs it to the variable attenuator 14a via the feeder 13. In the following description, when expressing any one of the induced signal 15 and the second noise signal 21, it is expressed as a "mast head amplifier signal 22".

The base station receiver 14 has the variable attenuator 14a, a frequency converter 14b, an intermediate frequency filter 14c, an intermediate frequency amplifier 14d, an output terminal 14e, a detector 14f, and a controller 14g. The amplifier 12d and the variable attenuator 14a are connected via the feeder 13.

When inputting the second noise signal 21 from the feeder 13, the variable attenuator 14a adjusts a second noise power 24 so that the second noise power 24 of the output terminal 14e is a predetermined value 25 to set a first gain 30 of the second noise signal 21. The attenuating is performed based on an adjusting signal 23 outputted from the controller 14g. The adjusting signal 23 requests the variable attenuator 14a to adjust an attenuation (a later-described first attenuation 26) based on information included therein.

The information included in the adjusting signal 23 has the predetermined value 25 to the second noise power 24 outputted from the output terminal 14e. The attenuation (hereinafter, called the "first attenuation 26") of the variable attenuator 14a is different depending on a second gain 31 of the second noise signal 21 of the mast head amplifier 12, an attenuation (which is also called a transmission loss and hereinafter, is called a "second attenuation 27") when the second noise signal 21 is transmitted via the feeder 13, and the predetermined value 25.

The variable attenuator 14a adjusts the induced signal 15 based on the set first gain 30 when inputting the induced signal 15 from the feeder 13. The second attenuation 27 is different depending on the length, type and maintenance conditions of the feeder 13. The difference of the second attenuation 27 is corrected by adjusting the first attenuation 26.

The frequency converter 14b converts the frequency of the mast head amplifier signal 22 outputted from the variable attenuator 14a. The intermediate frequency filter 14c removes the mast head amplifier signal 22 of an unnecessary frequency from the mast head amplifier signals 22 of a frequency converted and generated by the frequency converter 14b.

The intermediate frequency amplifier 14d amplifies the mast head amplifier signal 22 via the intermediate frequency filter 14c. The output terminal 14e outputs the mast head amplifier signal 22 of a frequency amplified by the intermediate frequency amplifier 14d. The detector 14f detects the power (outputted from the intermediate frequency amplifier 14d) at the output terminal 14e to output the detected result to the controller 14g. The power at the output terminal 14e is any one power (hereinafter, called a "mast head amplifier power 28") of the output power 18 and the second noise power 24.

When inputting the second noise power 24 from the detector 14f, the controller 14g outputs the adjusting signal 23 including information showing the second noise power 24 to the variable attenuator 14a to control the variable attenuator 14a. When inputting the output power 18 from the detector 14f, the controller 14g outputs the information showing the output power 18 to the variable attenuator 14a.

The controller 14g outputs the adjusting signal 23 to the variable attenuator 14a and outputs, to the switch 12c, a switch request signal 29 requesting switching of the connection of the switch 12c from the second first-stage amplifier 12b to the first first-stage amplifier 12a. The switch 12c switches the connection in response to the switch request signal 29 to select the first first-stage amplifier 12a.

The variable attenuator 14a has an alarm generation part 14aa. When detecting that the attenuation of the mast head amplifier signal 22 based on the adjusting signal 23 is not within a predetermined range, it gene rates an alarm for notifying abnormality.

The above-mentioned mast head amplifier 12 and the base station receiver 14 amplify the mast head amplifier signal 22. There will be considered the first noise power 20 (or the second noise power 24) corresponding to the first noise signal 17 (or the second noise signal 21) outputted from the first first-stage amplifier 12a (or the second first-stage amplifier 12b).

The first noise power 20 is amplified according to the following (1) equation via the first first-stage amplifier 12a of the mast head amplifier 12 and the base station receiver 14. In the (1) equation, K is a Boltzmann constant, T is an absolute temperature, B is a bandwidth in the intermediate frequency filter 14c, F1 is a first noise factor to the first first-stage amplifier 12a, G1 is a third gain 32 in the mast head amplifier 12 and the base station receiver 14 of the first noise power 20, and N1o is the first noise power 20 at the output terminal 14e.

$$N1o = K\,T \cdot B \cdot F1 \cdot G1 \qquad (1)$$

The first noise factor is expressed by (2) equation. In the (2) equation, F is the first noise factor, and Si, N1i are the signal power 19 and the first noise power 20, respectively, at the input terminal 12f connected to the first first-stage amplifier 12a. So, N1o are the signal power 19 and the first noise power 20, respectively, at the output terminal 14e. The values expressed by the denominator or the numerator of the (2) equation are called an S/N ratio.

$$F = (Si/N1i)/(So/N1o) \qquad (2)$$

The value of (So/N1o) is smaller than that of (Si/N1i). This is because the third gain 32 of the mast head amplifier 12 and the base station receiver 14 is the same to any of the signal power 19 and the first noise power 20 and noise is always produced in the amplification process. Actually, the S/N ratios cannot be calculated since the signal power 19 and the first noise power 20 cannot be measured separately.

Adjustment of the first noise power 20 cannot set the third gain 32 (G1). The following will be considered.

The second noise power 24 is amplified according to the following (3) equation via the second first-stage amplifier 12b of the mast heat amplifier 12 and the base station receiver 14. F2 is a second noise factor of the second first-stage amplifier 12b. G2 is the gain (the first gain 30) of the second noise power 24 in the mast head amplifier 12 and the base station receiver 14. N2o is the second noise power 24 at the output terminal 14e.

$$N2o = K \cdot T \cdot B \cdot F2 \cdot G2 \qquad (3)$$

When the switch 12c connects the second first-stage amplifier 12b and the amplifier 12d, the second noise signal 21 amplified by the second first-stage amplifier 12b is outputted to the amplifier 12d. The second noise signal 21 is further amplified by the amplifier 12d and is then outputted to the variable attenuator 14a via the feeder 13. The controller 14g controls the variable attenuator 14a (outputs the adjusting signal 23) to set the second noise power 24 corresponding to the second noise signal 21 to the predetermined value 25.

The switch 12c connects the first first-stage amplifier 12a and the amplifier 12d to select the first first-stage amplifier 12a. The first noise signal 17 amplified by the first first-stage amplifier 12a is outputted to the amplifier 12d. The first noise signal 17 is further amplified by the amplifier 12d to be outputted to the variable attenuator 14a via the feeder 13.

The case of (A) G1 = G2 and F1 = F2, and the case (B) other than the case (A) will be considered here.

In the case (A), when the connection of the switch 12c is switched from the second first-stage amplifier 12b to the first first-stage amplifier 12a, the gain and noise factor in the (1) and (2) equations are not changed. In this case, the variable attenuator 14a adjusts the output power 18 based on the first attenuation 26 when the second noise power 24 at the output terminal 14e is set to the predetermined value 25.

In the case (B), the difference between G1 and G2 must be known. In this case, the output power 18 is adjusted based on the first attenuation 26 adjusted to provide G1 = G2 based on the difference. The adjusting signal 23 outputted from the controller 14g to the variable attenuator 14a includes information showing the difference between G1 and G2 in addition to the predetermined value 25 and the second noise power 24 at the output terminal 14e.

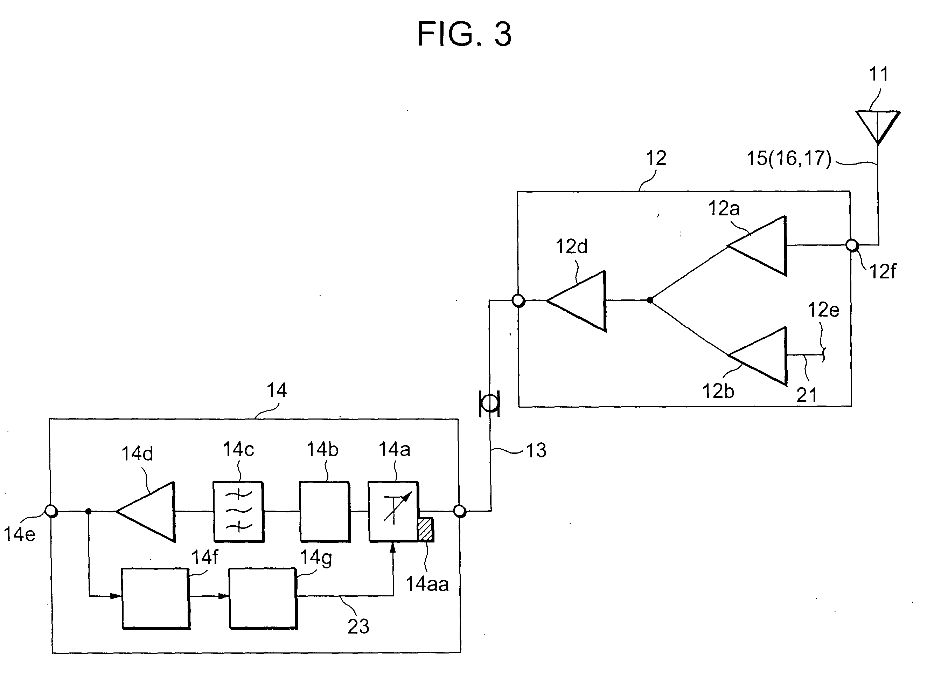

In the above construction, the connection of the amplifier 12d and the first first-stage amplifier 12a or the amplifier 12d and the second first-stage amplifier 12b is switched by the switch 12c. In the construction shown in FIG. 3, the switch 12c is not provided and the outputs from the first first-stage amplifier 12a and the second first-stage amplifier 12b are synthesized. In the construction, the switch request signal 29 outputted from the controller 14g controls ON/OFF of the operation of the first first-stage amplifier 12a and the second first-stage amplifier 12b. The construction includes the same components as those of the construction shown in FIG. 2 except that the control is done. The process done by the components is also the same.

In the construction shown in FIG. 2, the first first-stage amplifier 12a and the second first-stage amplifier 12b may be omitted. In this case, the first first-stage amplifier 12a and the second first-stage amplifier 12b have a gain of T and equally produce no noise. The attenuation of the output power 18 and the second noise power 20 at the switch 12c must be minimized.

## Embodiment 2

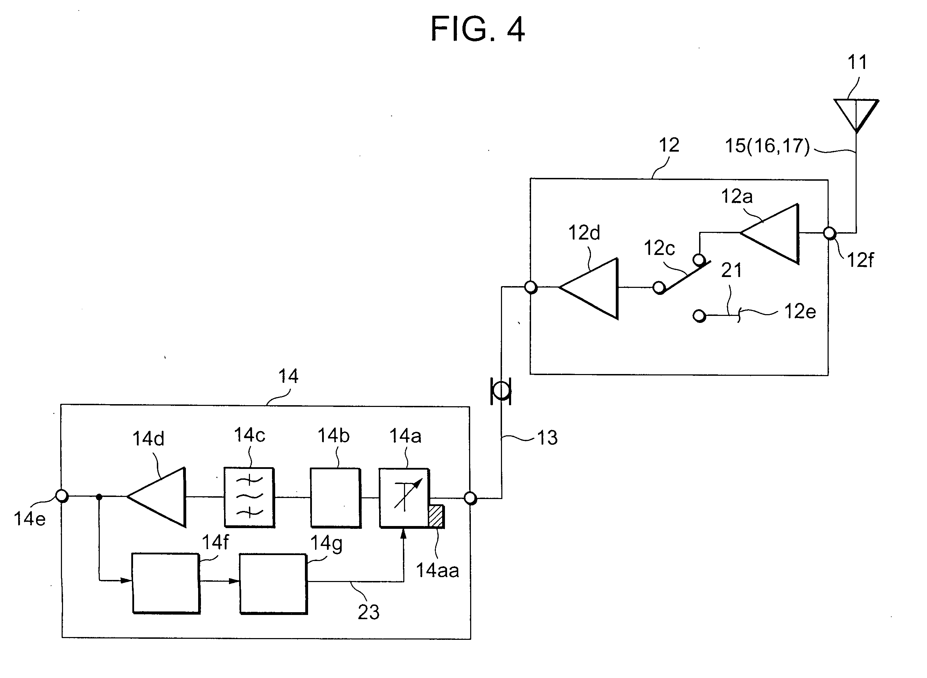

The construction of Embodiment 2 is shown in FIG. 4. In FIG. 4, the mast head amplifier 12 does not have the second first-stage amplifier 12b and the switch 12c switches the connection of the amplifier 12d and the first first-stage amplifier 12a or the amplifier 12d and the terminating set 12e to select any one device of the first first-stage amplifier 12a and the terminating set 12e.

The construction of Embodiment 2 does not have the second first-stage amplifier 12b. The second noise signal 21 in the terminating set 12e is outputted to the amplifier 12d to be further amplified. F3 is the noise factor of the amplifier 12d. G3 is the gain (the first gain 30) when the second noise signal 21 of the terminating set 12e is via the mast head amplifier 12 and the base station receiver 14. N3o is the second noise power 24 at the output terminal 14e. The relation of (4) equation is established.

$$N3o = K \cdot T \cdot B \cdot F3 \cdot G3 \qquad (4)$$

F4 is the noise factor of the amplifier 12d. G4 is the gain of the second noise signal 21 of the amplifier 12d. N4o is the second noise power 24 corresponding to the amplification of the base station receiver 14 of the second noise signal 21. The relation of (5) equation is established.

$$N4o = K \cdot T \cdot B \cdot F4 \cdot G4 \qquad (5)$$

The second noise power 24 (P1) in the terminating set 12e is amplified to a times via the amplifier 12d. The second noise power 24 (P2) inputted from the variable attenuator 14a is amplified to b times before reaching the output terminal 14e. At this time, aP1 is compared with a value (bP2 · P1/P2 = bP1) obtained by converting bP2. When the value of aP1 is larger, the second noise power 24 (aP1) can be detected by the detector 14f.

The same process of the components of Embodiment 2 as Embodiment 1 is performed except that the second noise power 24 in the terminating set 12e is outputted to the amplifier 12d not via the second first-stage amplifier 12b.

## Claims

1. A radio base station comprising:

a mast head amplifier selecting and outputting any one signal of a first signal inputted from a terminating set to be amplified and a second signal inputted from an antenna to be amplified; and
a base station receiver inputting said first signal for adjusting an intensity of an output signal to be a predetermined value to set a first gain and inputting said second signal for adjusting an intensity of an output signal based on said set first gain.

2. The radio base station as claimed in claim 1, wherein said first signal and said second signal are transmitted via a feeder connecting said mast head amplifier and said base station receiver.

3. The radio base station as claimed in claim 2, wherein said base station receiver inputs said first signal to adjust an intensity of an output signal based on said predetermined value and an attenuation when said first signal is transmitted via said feeder.

4. The radio base station as claimed in claim 2 or 3, wherein said mast head amplifier has:

a first first-stage amplifier connected to said terminating set to amplify and output a signal inputted from said terminating set;
a second first-stage amplifier connected to said antenna to amplify and output a signal inputted from said antenna;
a switch selecting any one first-stage amplifier of said first first-stage amplifier and said second first-stage amplifier; and
a first amplifier connecting said first-stage amplifier and said feeder and amplifying said signal outputted from said first-stage amplifier selected by said switch to output it to said feeder.

5. The radio base station as claimed in claim 2 or 3, wherein said mast head amplifier has:

a second first-stage amplifier connected to said antenna to amplify and output a signal inputted from said antenna;
a switch selecting any one device of said second first-stage amplifier and said terminating set; and
a first amplifier connecting said device and said feeder and amplifying said signal outputted from said device selected by said switch to output it to said feeder.

6. The radio base station as claimed in claim 3, 4 or 5, wherein said base station receiver has an attenuator, when inputting said first signal from said mast head amplifier, adjusting an intensity of an output signal based on said predetermined value and said attenuation to set said first gain, and when inputting said second signal from said mast head amplifier, adjusting an intensity of an output signal based on said set first gain.

7. The radio base station as claimed in claim 6, wherein said base station receiver further has:

a detection part inputting said first signal to detect an intensity of an output signal from said base station receiver;
a control part inputting said first signal to control said attenuator based on the intensity of the output signal detected by said detection part and said predetermined value; and
an alarm generation part notifying abnormality when the.

attenuation of said attenuator is not within a predetermined range.

8. A gain correcting method of a radio base station comprising the steps of:

   selecting and outputting a first signal obtained by amplifying a signal inputted from said terminating set in a mast head amplifier;
   selecting and outputting a second signal obtained by amplifying a signal inputted from said antenna in the mast head amplifier;
   inputting said first signal for adjusting an intensity of an output signal to be a predetermined value to set a first gain in a base station receiver; and
   inputting said second signal for adjusting an intensity of an output signal based on said set first gain in the base station receiver.

9. The method as claimed in claim 8, wherein said first signal and said second signal are transmitted via a feeder connecting said mast head amplifier and said base station receiver.

10. The method as claimed in claim 9, wherein said base station receiver inputs said first signal to adjust an intensity of an output signal based on said predetermined value and an attenuation when said first signal is transmitted via said feeder.

11. The method as claimed in claim 8, 9 or 10, wherein when the adjusted intensity of said output signal is not within a predetermined range, abnormality is notified.

FIG. 1

# FIG. 2

EP 1 337 049 A2

FIG. 3

# FIG. 4

EP 1 337 049 A2